# EUROPEAN PATENT APPLICATION

(11) **EP 1 719 823 A1**
(43) Date of publication of application: **08.11.2006**
(21) Application number: 05703340.9
(22) Date of filing: 06.01.2005
(51) Int. Cl.: C23C 14/48, C01B 31/02, H01L 21/265, H01L 51/00, H01L 29/06, H01M 8/02, H01B 13/00, H01J 37/317

(54) **ION IMPLANTATION SYSTEM AND ION IMPLANTATION SYSTEM**

(30) Priority: 06.01.2004 JP 2004001362
(71) Applicant: Ideal Star Inc., Sendai-shi, Miyagi 989-3204 (JP)
(72) Inventor: KASAMA, Yasuhiko, Sendai-shi, Miyagi 9818007 (JP); OMOTE, Kenji, Sendai-shi, Miyagi 9813222 (JP); YOKOH, Kuniyoshi, Sendai-shi, Miyagi 9820801 (JP)
(74) Representative: Dr. Weitzel & Partner
(86) International application number: PCT/JP2005/000072
(87) International publication number: WO 2005/066385

(57) **Abstract**

In a containing-fullerene production method for giving acceleration energies to containment target atom ions by using an acceleration electrode to thereby implant the containment target atoms into an empty fullerene film previously formed on a deposition-assistance substrate, charged particles constituting an ion beam are only containment target atom ions having the same polarity, so that repulsive forces act between the charged particles, and the ion beam is diverged particularly in case of ion implantation with a low energy, thereby problematically making it difficult to implant ions at a high density into the fullerene film, and decreasing a yield of containing-fullerene. Thus, it is devised to transport plasma including charged particles made of containment target atom ions and charged particles of a polarity opposite to that of the containment target atom ions, up to an empty fullerene film on a deposition-assistance substrate by a uniform magnetic field generated by magnetic field generating means, and to give acceleration energies to the containment target atoms by a bias voltage applied to the deposition-assistance substrate, thereby implanting the containment target atoms into the fullerene film. Since attractive forces act between the charged particles constituting the plasma so that the plasma is not diverged, it becomes possible to achieve a high density ion implantation to improve a yield of containing-fullerene even in ion implantation with a low energy.

## Description

### TECHNICAL FIELD

The present invention relates to an ion implantation method and an ion implantation apparatus configured to irradiate a plasma flow including implantation target ions onto an organic material film or polymer material film on a deposition-assistance substrate, thereby forming an ion implanted film such as containing-fullerene.

### BACKGROUND ART

Patent Document 1: JP-A-9-180662

Non-Patent Document 1: E. E. B. Cambell, R. Tellgmann, N. Krawez, and I. V. Hertel, J. Phys. Chem Solids Vol 58, No. 11, pp. 1763-1769, 1997

Non-Patent Document 2: "Nature and Application of Fullerene Plasma", Journal of Plasma/Nuclear Fusion Academic Society, Vol. 75, No. 8, pp. 927-933, August 1999

Containing-fullerenes are materials which are made of spherical carbon molecules such as C₆₀, C₇₀, C₇₆, C₇₈, C₈₂, C₈₄ known as fullerenes and atoms such as alkali metal contained therein, and which are expected to be applied to electronics, medical treatment, and the like. Known as production methods of containing-fullerene are: a method (ion implantation method) configured to derive an ion beam of containment target atoms from plasma of containment target atoms generated within a vacuum chamber by means of an acceleration voltage applied to an acceleration electrode, and to drive containment target atom ions into an empty fullerene film deposited on a deposition-assistance substrate, thereby causing the containment target atoms to be contained in fullerene molecules; and a method (fullerene plasma reaction method) configured to generate a plasma flow made of containment target atom ions within a vacuum chamber, to introduce fullerene vapor into the generated plasma flow to thereby ionize fullerene molecules, and to react containment target atom ions and fullerene ions having mutually different polarities with each other near a deposition-assistance substrate arranged downstream of the plasma flow, thereby depositing a containing-fullerene film.

(Containing-Fullerene Production Apparatus based on Ion Implantation Method)

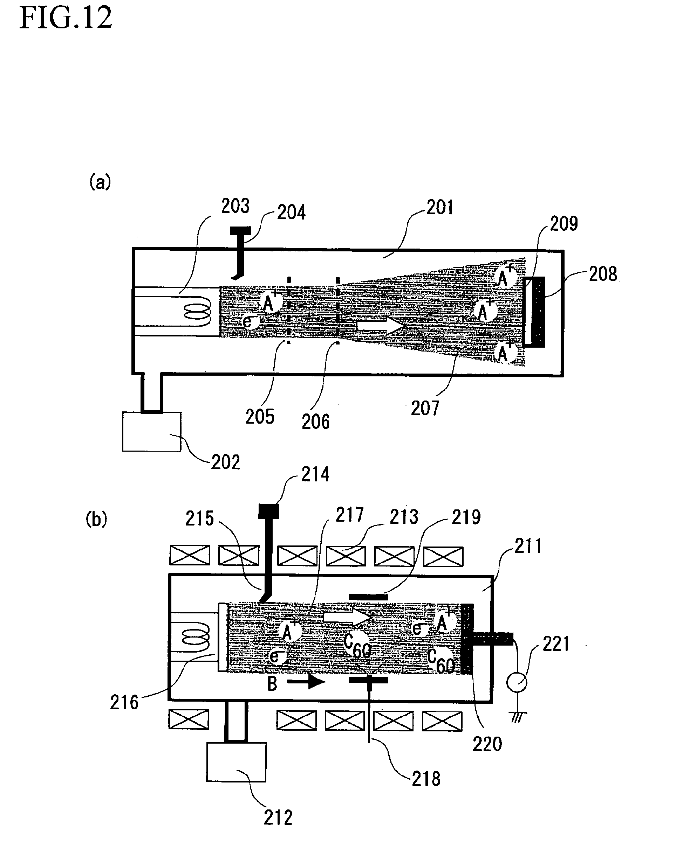

FIGS. 12(a) and (b) are cross-sectional views of conventional containing-fullerene production apparatuses, respectively. The conventional containing-fullerene production apparatus shown in FIG. 12(a) is constituted of a vacuum chamber, an ion source, acceleration electrodes, and a deposition-assistance substrate. The vacuum chamber 201 is evacuated to a vacuum degree of about 10⁻⁴ Pa by means of a vacuum pump 202. The ion source is constituted of a thermoelectron discharge device 203 such as a heating filament, and an alkali metal vapor introduction device 204. Thermoelectrons discharged from the thermoelectron discharge device 203 collide with atoms such as alkali metal introduced by the alkali metal vapor introduction device 204 to thereby ionize the atoms, thereby generating plasma including alkali metal ions and electrons represented by A⁺ and e⁻ in FIG. 12(a), respectively. From the plasma generated by the ion source, there are taken out only alkali metal ions by one or multiple acceleration electrodes such as acceleration electrodes 205, 206 to thereby give acceleration energies to the alkali metal ions, and the alkali metal ions are implanted into an empty fullerene film 209 previously deposited on a deposition-assistance substrate 208. Ions to be implanted each have an energy which is controlled by the acceleration electrodes in a range of 20 eV to 500 eV (Non-Patent Document 1).

(Containing-Fullerene Production Apparatus based on Fullerene Plasma Method)
Shown in FIG. 12(b) is a conventional containing-fullerene production apparatus based on a fullerene plasma reaction method, which is constituted of a vacuum chamber, an electromagnetic coil, a plasma generation device, fullerene introduction means, a deposition-assistance substrate, and bias voltage application means. The vacuum chamber 211 is evacuated to a vacuum degree of about 10⁻⁴ Pa by a vacuum pump 212. The plasma generation device is constituted of a heating filament, a hot plate 216, an alkali metal sublimation oven 214, and an alkali metal vapor introduction pipe 215. Injecting alkali metal vapor generated by the sublimation oven 214 onto the hot plate 216 from the alkali metal vapor introduction pipe 215, generates plasma made of alkali metal ions and electrons by contact ionization.

The generated plasma is confined in an axial direction within the vacuum chamber 211 along a uniform magnetic field (B = 2 to 7 kG) formed by the electromagnetic coil 213, and becomes a plasma flow flowing from the hot plate 216 toward the deposition-assistance substrate 220. The fullerene introduction means is constituted of a fullerene sublimation oven 218 and a re-sublimation cylinder 219. Injecting fullerene molecules such as C₆₀ sublimated from the fullerene sublimation oven 218 into the plasma flow, causes electrons constituting the plasma flow to attach to C₆₀ having a larger electron affinity, thereby generating negative ions of C₆₀. As a result, the plasma flow is brought into one mixedly including alkali metal ions, fullerene ions, and residual electrons by the following formula in case of adoption of sodium as alkali metal, for example:

Na → Na⁺ + e⁻

C₆₀ + e⁻ → C₆₀⁻

The deposition-assistance substrate 220 is arranged downstream of such a plasma flow and there is applied a positive bias voltage thereto, thereby decelerating alkali metal ions having smaller masses and higher velocities, and accelerating fullerene ions having larger masses and lower velocities, to increase interaction between alkali metal ions and fullerene ions and facilitate occurrence of containment (Non-Patent Document 2).

### DISCLOSURE OF THE INVENTION

### Problem to be solved by the Invention

(Containing-Fullerene Production Apparatus based on Ion Implantation Method)
In the method where acceleration energies are given to containment target atom ions by the acceleration electrodes to thereby implant ions into the empty fullerene film previously formed on the deposition-assistance substrate, charged particles constituting an ion beam to be irradiated to the deposition-assistance substrate are only made of ions having either positive or negative polarity. For example, ions constituting an ion beam are made of positive ions only, when containment target atoms are alkali metal or nitrogen, whereas ions constituting an ion beam are made of negative ions only, when containment target atoms are halogen elements.

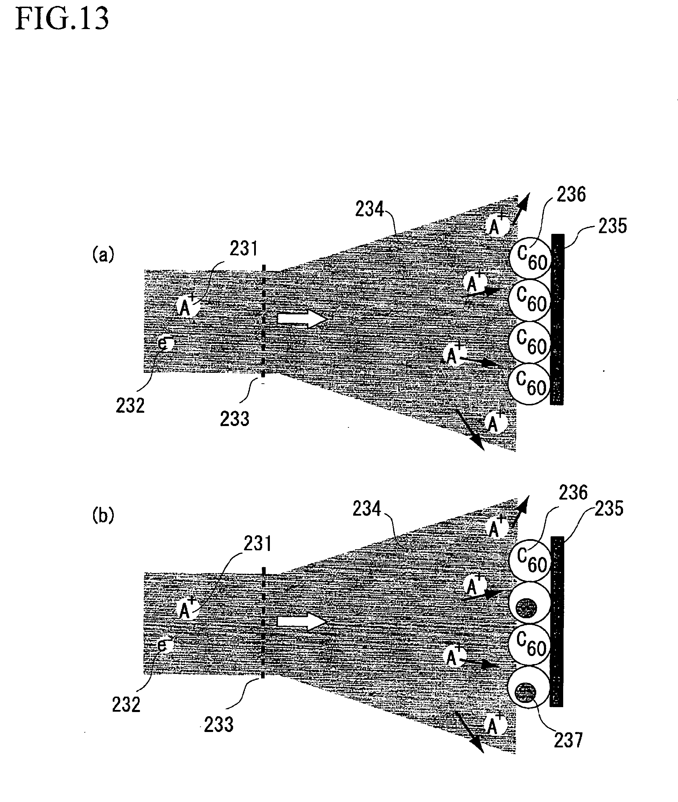

FIGS. 13(a) and 13(b) are explanatory views of the containing-fullerene formation process adopting the conventional ion implantation methods. In FIG. 13(a), there is applied a negative acceleration voltage in a range of 20 eV to 500 eV to plasma made of alkali metal ions 231 and electrodes 233, by an acceleration electrode 233. This acceleration voltage range leads to an extremely low acceleration voltage, as compared with an acceleration voltage in a range of 10 KeV to 200 KeV to be used in an ion implantation method in a typical process for adopting an inorganic semiconductor material such as silicon. This is because, excessively higher acceleration energies lead to a possibility of breakage of a cage of fullerene acting as an organic material. In turn, excessively lower acceleration energies lead to failure of passage of containment target atom ions into fullerene cages, so that acceleration voltages of 20 eV or higher are required. Positive alkali metal ions constituting the plasma are accelerated by the acceleration electrode having a negative voltage applied thereto, and implanted into an empty fullerene film 236 deposited on a deposition-assistance substrate 235.

In the conventional ion implantation method shown in FIG. 13(a), charged particles included in an ion beam 234 are positive ions only, so that repulsive forces act between charged particles to diverge the ion beam 234, thereby making it difficult to increase an ion density per unit area. This leads to a lower ion density of containment target atoms to be implanted such that ions are implanted into part of fullerenes on the deposition-assistance substrate, thereby forming containing-fullerene 236, as shown in FIG. 13(b). As such, this has resulted in a problem of a lower content (yield) of containing-fullerene in the deposited film on the deposition-assistance substrate. Particularly, in case of ion implantation at a lower acceleration energy such as ion implantation into an organic material such as fullerene, ion beams tend to diverge, thereby making it difficult to attain implantation based on high-density ion beams.

Further, ion beams are diverged as shown in FIG. 13(b), thereby increasing the number of ions to be exemplarily attached onto an inner wall of the production apparatus without irradiation to the deposition-assistance substrate 235. Examples of containment target atoms include a material such as Na which is corrosive and violently reacts with water, thereby additionally causing problems of workability and safety in maintenance of the production apparatus.

(Conventional Ion Implantation Apparatus for Preventing Divergence of Ion Beam)
There has been known an ion implantation apparatus aiming at prevention of ion beam divergence and constituted of: an ion source for generating ion beams; a magnetic field type mass separator for separating specific ion species from among ion beams derived from the ion source; an ion driving chamber for driving mass-separated ion beams into a sample substrate; and an accelerator for further accelerating the mass-separated ions; wherein radio waves comprising microwaves and a small amount of discharge gas are introduced into an analysis tube of the magnetic field type mass separator to thereby generate plasma within the analysis tube; thereby rather exhibiting a problem that the apparatus is complicated in structure because the same requires the mass separator as well as a plasma generation device for neutralizing ion beams, in addition to the ion source (Patent Document 1).

(Containing-Fullerene Production Apparatus based on Fullerene Plasma Method)
In case of the conventional containing-fullerene production method adopting the fullerene plasma reaction method, it is devised to apply a bias voltage to the deposition-assistance substrate to control movement velocities of light-weight containment target atom ion A⁺ and heavy fullerene ion C₆₀⁻, thereby increasing a probability of occurrence of containment reaction. Then, excessively higher collision energies between containment target atom ions and fullerene ions lead to breakage of containing-fullerenes, whereas excessively lower collision energies rarely lead to containment. It is thus necessary to simultaneously optimize a collision probability and attain an optimum value of collision energy, for an increased yield of containing-fullerene. However, the bias voltage suitable for improving a collision probability is not necessarily coincident with that for optimizing a collision energy, thereby exhibiting a problem that the conventional fullerene plasma reaction method fails to sufficiently increase a yield of containing-fullerene.

For production of containing-fullerene not only for an investigative purpose but also for an industrial purpose, there has been demanded a method for transporting ions at a high density with a low energy, thereby producing containing-fullerene at a higher yield.

For the purpose of solving the above-mentioned problems, it is therefore an object of the present invention to provide a production method and a production apparatus for transporting ions at a high density and a higher convergence even with a low energy onto a deposition-assistance substrate, thereby producing an ion implantation product such as containing-fullerene at a higher efficiency.

### Means for solving the Problem

The present invention (1) resides in an ion implantation method, characterized in that the method comprises the steps of:
generating, by plasma generation means, plasma at least including implantation target ions and charged particles of a polarity opposite to that of the implantation target ions;
transporting the plasma onto a deposition-assistance substrate under an influence of a magnetic field;
giving acceleration energies to the implantation target ions by a bias voltage applied by the deposition-assistance substrate;
irradiating the plasma toward the deposition-assistance substrate; and
implanting the implantation target ions into a material film on the deposition-assistance substrate.

The present invention (2) resides in the ion implantation method of the invention (1), characterized in that the bias voltage has a polarity opposite to that of the implantation target ions.

The present invention (3) resides in the ion implantation method of the invention (1) or invention (2), characterized in that the plasma is irradiated to the material film deposited on the deposition-assistance substrate, to implant the implantation target ions into the material film.

The present invention (4) resides in the ion implantation method of the invention (1) or invention (2), characterized in that the plasma is irradiated toward the deposition-assistance substrate simultaneously with deposition of the material film onto the deposition-assistance substrate, to implant the implantation target ions into the material film.

The present invention (5) resides in the ion implantation method of the invention (1) or invention (2), characterized in that the implantation target ions are implanted into the material film by repeating:
a step of depositing a material film on the deposition-assistance substrate; and
the step of irradiating the plasma toward the deposition-assistance substrate.

The present invention (6) resides in the ion implantation method of the invention (1) through invention (5), characterized in that the ions are implanted into the material film comprising fullerene to produce containing-fullerene or hetero-fullerene.

The present invention (7) resides in the ion implantation method of the invention (6), characterized in that the acceleration energies are within a range of 10 eV inclusive to 500 eV inclusive.

The present invention (8) resides in the ion implantation method of the invention (6), characterized in that the acceleration energies are within a range of 20 eV inclusive to 500 eV inclusive.

The present invention (9) resides in the ion implantation method of the inventions (1) through invention (5), characterized in that the material film is carbon nanotube, a material film of organic EL, a material film of solar cell, a material film of fuel cell, an organic semiconductor material film, or an electroconductive polymer material film.

The present invention (10) resides in the ion implantation method of invention (9), characterized in that the acceleration energies are within a range of 0.5 eV inclusive to 500 eV inclusive.

The present invention (11) resides in the ion implantation method of the invention (1) through invention (10), characterized in that the implantation target ions have an ionic current density of 1 µA/cm² or more.

The present invention (12) resides in the ion implantation method of the invention (1) through invention (11), characterized in that the implantation target ions are implanted, by arranging a grid electrode in the plasma and separatedly from the deposition-assistance substrate to thereby control a plasma potential by a voltage applied to the grid electrode.

The present invention (13) resides in the ion implantation method of the invention (12), characterized in that the grid electrode is located at a distance in a range of 1 mm inclusive to 50 mm inclusive from the deposition-assistance substrate.

The present invention (14) resides in the ion implantation method of the invention (1) through invention (13), characterized in that the implantation target ions are implanted, by providing the deposition-assistance substrate in a form of a plurality of divisional deposition-oriented plates in concentric circle shapes, and by independently controlling bias voltages applied to the plurality of deposition-oriented plates, respectively.

The present invention (15) resides in the ion implantation method of the invention (8) through invention (14), the implantation target ions are implanted, by cooling the deposition-assistance substrate by cooling means.

The present invention (16) resides in an ion implantation apparatus comprising:
a vacuum vessel;
plasma generation means for generating plasma at least including implantation target ions and charged particles of a polarity opposite to that of the implantation target ions, within the vacuum vessel;
magnetic field generating means;
a deposition-assistance substrate arranged within the vacuum vessel;
bias voltage application means for applying a bias voltage to the deposition-assistance substrate; and
material film deposition means for depositing a material film onto the deposition-assistance substrate.

The present invention (17) resides in an ion implantation apparatus comprising:
a vacuum vessel;
plasma generation means for generating plasma at least including implantation target ions and charged particles of a polarity opposite to that of the implantation target ions, within the vacuum vessel;
magnetic field generating means;
a deposition-assistance substrate arranged within the vacuum vessel; and
bias voltage application means for applying a bias voltage to the deposition-assistance substrate.

The present invention (18) resides in the ion implantation apparatus of the invention (16) or invention (17), characterized in that the deposition-assistance substrate comprises a conveyor or rotary cylinder.

The present invention (19) resides in the ion implantation apparatus of the invention (16) or invention (17), characterized in that the apparatus includes a transport device comprising a belt conveyor or rotary cylinder, and
that the transport device is configured to support and transport a plurality of the deposition-assistance substrates within the vacuum device.

The present invention (20) resides in the ion implantation apparatus of the invention (19), characterized in that the deposition-assistance substrates are each supported to the transport device by an electroconductive clamp member.

The present invention (21) resides in the ion implantation apparatus of the invention (19) or invention (20), characterized in that the ion implantation apparatus further comprises cooling means for cooling the deposition-assistance substrate.

### Effect of the Invention

1. Ion implantation is achieved by transporting plasma including implantation target ions and charged particles of a polarity opposite to that of the implantation target ions by a magnetic field, so that attractive forces act between the charged particles constituting the plasma, thereby rarely diverging the plasma. It is thus possible to achieve a high density ion implantation even with a low energy, by using a production apparatus of a simple configuration.
2. It is possible to irradiate a plasma having an excellent convergence toward a deposition-assistance substrate, thereby enabling a lesser amount of plasma to be irradiated to an inner wall of the apparatus other than the deposition-assistance substrate, to decrease contamination of the apparatus. Maintenance work is facilitated, and usage efficiencies of starting materials are enhanced.
3. The ion density of implantation target ions is increased to enable improvement of a collision probability between the implantation target ions and molecules constituting a material film, and controlling a bias voltage applied to a deposition-assistance substrate allows for control of acceleration energies of implantation target ions. Since the collision probability and the acceleration energies can be independently controlled by different process parameters, the controllability of the ion implantation process can be improved.
4. Fullerenes such as containing-fullerene, hetero-fullerene and the like can be produced at a good efficiency, thereby enabling mass-production of fullerenes for industrial utilization.
5. It is possible to achieve high density ion implantation with a low energy, for an organic material, polymer material, and the like which are susceptible to damage by achievement of ion implantation with a high energy.
6. According to the ion implantation method of the present invention in the manner to simultaneously or alternately conduct deposition of a material film and irradiation of a plasma flow, it becomes possible to implant ions uniformly in a thickness direction of a material film, which is useful for mass-production of fullerenes and doping of impurities.
7. According to the method of the present invention configured to achieve ion implantation by irradiating plasma to a material film deposited on a deposition-assistance substrate, it is unnecessary to provide, in the vacuum apparatus, a deposition apparatus of a material film except for the ion implantation apparatus, thereby simplifying the apparatus configuration.
8. According to the ion implantation method of the present invention to control a plasma potential by a grid electrode, it becomes possible to control an extent of region influenced by a bias voltage applied to the deposition-assistance substrate, thereby enabling an improved convergence of plasma flow.
9. According to the ion implantation method of the present invention to adopt a deposition-assistance substrate made of divisional plates, it becomes possible to achieve ion implantation uniformly within planes of the deposition-assistance substrates even by plasma having a non-uniform in-plane density distribution of ions, thereby enabling an improved yield of ion implantation product.
10. According to the ion implantation apparatus of the present invention adopting the continuous processing system, it becomes possible to continuously and automatically achieve supply of starting material of implantation target ion, supply of starting material of material film, deposition of material film, ion implantation, and collection of product, thereby enabling mass-production of an ion implantation product.

### BRIEF DESCRIPTION OF THE DRAWINGS

[FIG. 1] (a) and (b) are cross-sectional views of a first concrete example and a second concrete example of an ion implantation apparatus of the present invention, respectively.
[FIG. 2] (a) and (b) are cross-sectional views of a third concrete example and a fourth concrete example of an ion implantation apparatus of the present invention, respectively.
[FIG. 3] (a) and (b) are explanatory views of a containing-fullerene generation process adopting an ion implantation method of the present invention, respectively.
[FIG. 4] (a) and (b) are explanatory views of a containing-fullerene generation process adopting an ion implantation method of the present invention, respectively.
[FIG. 5] (a), (b), and (c) are explanatory views of a function of a grid electrode according to the ion implantation apparatus of the present invention, respectively.
[FIG. 6] (a), (b), and (c) are explanatory views of a function of a divided substrate according to the ion implantation apparatus of the present invention, respectively.
[FIG. 7] A cross-sectional view according to an ion implantation apparatus of the present invention provided with a continuous processing system.
[FIG. 8] (a) through (f) are perspective views of concrete examples of deposition-assistance substrates according to the continuous processing system of the ion implantation apparatus of the present invention, respectively.
[FIG. 9] (a) and (b) are cross-sectional views of deposition-assistance substrates provided with electrical conduction means and cooling means in the ion implantation apparatus of the present invention, respectively.
[FIG. 10] A graph of a mass spectrometry result of Na-containing C₆₀ produced by the ion implantation method of the present invention.
[FIG. 11] A graph of an implantation energy dependency of a yield of Na-containing C₆₀.
[FIG. 12] (a) and (b) are cross-sectional views of conventional containing-fullerene production apparatuses, respectively.
[FIG. 13] (a) and (b) are explanatory views of a containing-fullerene formation process adopting the conventional ion implantation method, respectively.

### Explanation of reference numerals

- 1, 21, 41, 61, 141: vacuum chamber
- 2, 22, 42, 62, 142: vacuum pump
- 3, 23, 43, 47, 48, 63, 143: electromagnetic coil
- 4, 24, 144: alkali metal sublimation oven
- 5, 25, 145: alkali metal vapor introduction pipe
- 6, 26, 146: hot plate
- 7, 27, 67, 147, 161: plasma flow
- 8, 54, 149: fullerene sublimation oven
- 9, 55, 150: fullerene vapor introduction pipe
- 10, 28, 56, 68, 165, 166, 169: substrate
- 11, 29, 57, 69, 153: deposited film
- 12, 30, 58, 70, 154: bias voltage application oriented power supply
- 148: continuous processing system
- 150: drive roller
- 152, 162: belt conveyor
- 155: gate valve
- 156: load lock chamber
- 163: plasma flow shield plate
- 164: opening portion
- 167: rotary cylinder
- 168: rotational shaft
- 44: microwave transmitter
- 45, 64: gas introduction pipe
- 46, 65: plasma generation chamber
- 49: PMH antenna
- 50: plasma
- 51: electron temperature control electrode
- 52: electron temperature control power supply
- 53, 101, 111, 121, 125: plasma flow
- 71: grid electrode
- 72: grid voltage application oriented power supply
- 102, 112: positive ion
- 103: electron
- 104, 114, 122, 126, 127, 132, 133, 134, 135: deposition-assistance substrate
- 105, 115, 123, 128, 129: deposited film
- 106, 116, 124, 130, 134: bias voltage application oriented power supply
- 107, 117: first grid electrode
- 118: second grid electrode
- 119: grid voltage application oriented power supply
- 113: negative ion
- 171, 181: deposition-assistance substrate support member
- 172, 182: plastic substrate
- 173, 183: ITO electrode
- 174, 184: organic material film
- 175, 185: clamp member
- 176, 186: cooling means
- 177, 187: bias voltage application oriented power supply
- 81, 91: plasma flow
- 82: fullerene vapor introduction pipe
- 83, 92: substrate
- 84, 93: bias voltage application oriented power supply
- 85, 94, 231: positive ion
- 86, 95, 236: fullerene molecule
- 87, 96, 232: electron
- 88, 97, 237: containing-fullerene molecule
- 201, 211: vacuum chamber
- 202, 212: vacuum pump
- 203: thermoelectron discharge device
- 204: alkali metal vapor introduction device
- 205, 206, 233: acceleration electrode
- 207, 234: ion beam
- 208, 220, 235: substrate
- 209: deposited film
- 213: electromagnetic coil
- 214: alkali metal sublimation oven
- 215: alkali metal vapor introduction pipe
- 216: hot plate
- 217: plasma flow
- 218: fullerene sublimation oven
- 219: re-sublimation cylinder
- 221: bias voltage application oriented power supply
- 231: positive ion
- 232: electron
- 233: acceleration electrode
- 234: ion beam
- 235: substrate

### BEST MODES FOR CARRYING OUT THE INVENTION

There will be explained a best mode of the present invention.

(Ion Implantation Method)
The present invention resides in an ion implantation method characterized in that the method comprises the steps of: generating implantation target ions, and plasma including charged particles of a polarity opposite to that of the implantation target ions; transporting the plasma onto a deposition-assistance substrate, under an influence of a magnetic field; giving acceleration energies to the implantation target ions, by a bias voltage applied to the deposition-assistance substrate; irradiating the plasma toward the deposition-assistance substrate; and implanting the implantation target ions into a material film on the deposition-assistance substrate.

It is possible to select a method for forming a material film on a deposition-assistance substrate, from the following ones:
1. To arrange, within an ion implantation apparatus, a vapor introduction part for injecting a vapor made of atoms or molecules for constituting a material film toward a deposition-assistance substrate, in a manner to irradiate containment target atom plasma toward the deposition-assistance substrate simultaneously with deposition of a material film on the deposition-assistance substrate, thereby conducting ion implantation. Without limited to a vapor deposition method for deposition of the material film, it is possible to adopt a deposition method such as sputtering method, CVD method, or the like.
2. To arrange a continuous processing system in the ion implantation apparatus of the present invention provided with a deposition apparatus for a material film, in a manner to alternately repeat deposition of an extremely thin material film and an ion implantation, thereby eventually obtaining a product film of a predetermined film thickness. The process control is conducted by synchronizing the deposition apparatus of a material film and the ion implantation apparatus with each other.
3. To deposit a material film on a substrate by a deposition apparatus, and then to implant implantation target ions into the material film by the ion implantation apparatus of the present invention. The deposition apparatus and the ion implantation apparatus may be mutually independent vacuum apparatuses (ex-situ process) or the same vacuum apparatus (in-situ process).

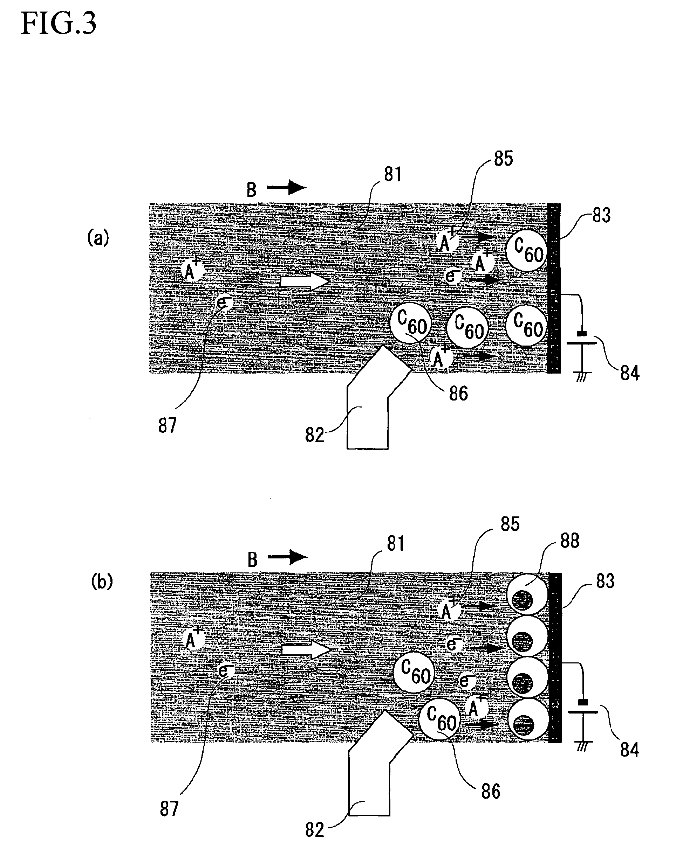

FIGS. 3(a) and (b) are explanatory views, respectively, in a situation concerning a containing-fullerene generation process adopting an ion implantation method of the present invention, where fullerene vapor is injected onto a deposition-assistance substrate, and a plasma flow including alkali metal ions is irradiated onto the deposition-assistance substrate, thereby forming alkali-metal-containing fullerene on the deposition-assistance substrate. The injection of fullerene vapor and the irradiation of plasma flow may be conducted simultaneously or alternately.

In FIG. 3(a), the plasma flow 81 is plasma made of positive ions 85 of alkali metal and electrons 87. Charged particles constituting the plasma flow 81 are moved toward the deposition-assistance substrate 83, under an influence of a magnetic field generated by an electromagnetic coil or magnet. The plasma flow 81 includes positive ions, and electrons acting as negative charged particles, each present substantially at the same density, such that charged particles of both types exert attractive forces on each other, thereby rarely causing divergence. This allows positive ions at a high density to be transported toward the deposition-assistance substrate 83.

In FIG. 3(b), injection of fullerene molecules 86 and irradiation of the plasma flow 81 toward the deposition-assistance substrate 83 are conducted simultaneously or alternately. Since the deposition-assistance substrate 83 has a negative bias voltage applied thereto by a bias voltage application oriented power supply 84, alkali metal ions 85 obtain acceleration energies, collide with fullerene molecules deposited on the deposition-assistance substrate 83, and are contained in fullerene molecules and brought into containing-fullerenes 88, respectively.

In case of implantation of ions into a material film, implanted ions exhibit a depth-wise density distribution having a peak near a surface of the material film. As such, in case of implanting ions from a surface of a thick material film, the amount of implanted ions is decreased in a region separated from the surface of the material film. Nonetheless, it is possible to implant ions relatively uniformly in a depth-wise direction of a material film according to the method of the present invention configured to simultaneously or alternately conduct deposition of a material film and irradiation of a plasma flow, thereby providing a method which is advantageous when it is desired to increase a yield of product such as containing-fullerene or hetero-fullerene, or when it is desired to uniformly dope impurities in a depth-wise direction as well in case of impurity doping.

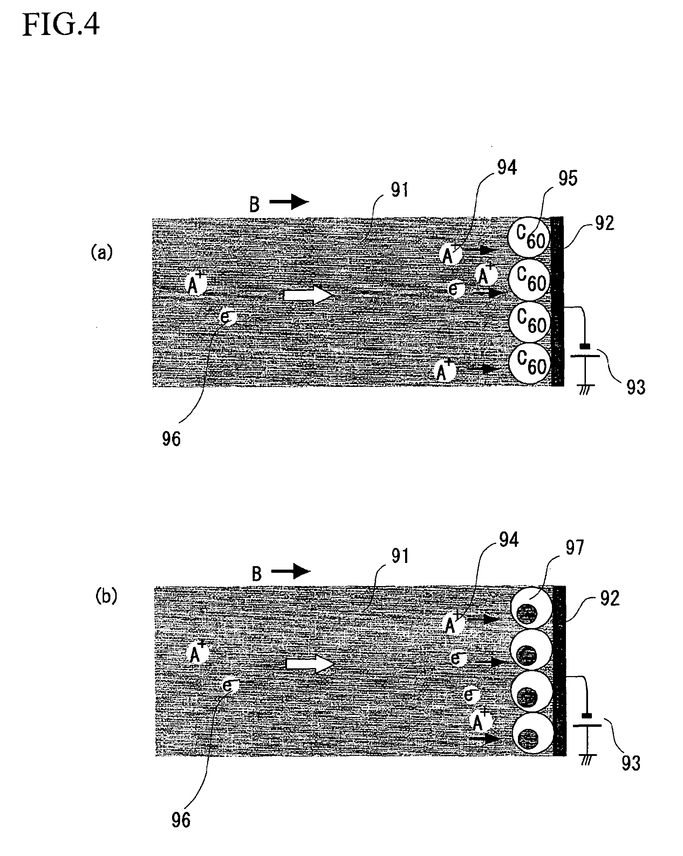

FIGS. 4(a) and (b) are explanatory views, respectively, in a situation concerning a containing-fullerene generation process adopting an ion implantation method of the present invention, where a plasma flow including alkali metal ions is irradiated to a fullerene film deposited on a deposition-assistance substrate, thereby forming alkali-metal-containing fullerene.

In FIG. 4(a), the plasma flow 91 is plasma made of positive ions 94 of alkali metal and electrons 96. Charged particles constituting the plasma flow 91 are moved toward the deposition-assistance substrate 92, under an influence of a magnetic field generated by an electromagnetic coil or magnet. The plasma flow 91 includes positive ions, and electrons acting as negative charged particles, each present substantially at the same density, such that charged particles of both types exert attractive forces on each other, thereby rarely causing divergence. This allows positive ions at a high density to be transported toward the deposition-assistance substrate 92. The deposition-assistance substrate 92 has a thin-film deposited thereon and made of fullerene molecules 95.

In FIG. 4(b), since the deposition-assistance substrate 92 has a negative bias voltage applied thereto by a bias voltage application oriented power supply 93, alkali metal ions 94 obtain acceleration energies, collide with fullerene molecules deposited on the deposition-assistance substrate 92, and are contained in fullerene molecules and brought into containing-fullerenes 97, respectively.

Although ions are implanted into only a surface of the material film in the method of the present invention for implanting ions into a material film deposited on the deposition-assistance substrate, this is an advantageous method in that an apparatus configuration can be simplified because it is unnecessary to arrange a deposition apparatus of a material film within the ion implantation apparatus in case of sufficiently thin material films or in case that it is sufficient to dope impurities into only a surface of a material film.

(Ion Implantation Apparatus)
There will be explained an ion implantation apparatus of the present invention with reference to concrete examples shown in the drawings.

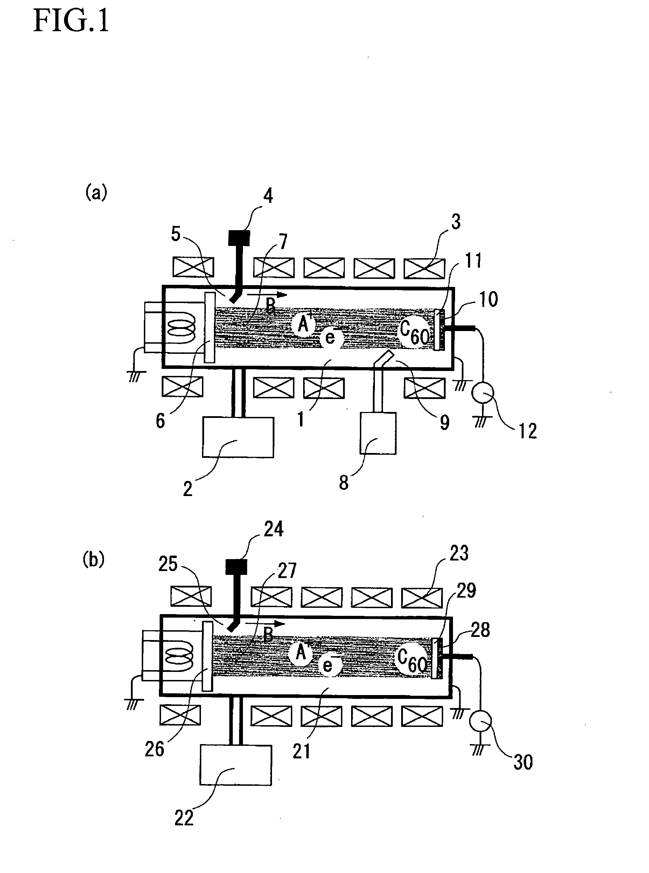

First Concrete Example
FIG. 1(a) is a cross-sectional view according to a first concrete example of an ion implantation apparatus of the present invention. The first concrete example of the present invention is an ion implantation apparatus configured to generate plasma made of alkali metal ions by a plasma generation device of a contact ionization type, irradiate the generated plasma toward a deposition-assistance substrate, and simultaneously inject fullerene vapor toward the deposition-assistance substrate, thereby producing alkali-metal-containing fullerene.

Vacuum chamber 1 is evacuated to a vacuum of about 10⁻⁴ Pa by a vacuum pump 2. Alkali metal sublimation oven 4 sublimates alkali metal filled in the oven, and alkali metal vapor is injected against a hot plate 6 by an alkali metal vapor introduction pipe 5. The alkali metal vapor is ionized on the hot plate 6, thereby generating plasma made of alkali metal ions and electrons.

Arranged around the vacuum chamber 1 is an electromagnetic coil 3, thereby influencing a uniform magnetic field (B = 2 to 7 kG) on the generated plasma. Ions and electrons constituting the plasma exhibit a circular motion called a Larmor motion within a plane orthogonal to a magnetic field direction. As such, the plasma is confined within a space having substantially the same shape of cross section as the hot plate, and is established into a plasma flow which flows by diffusion from the hot plate 6 toward a deposition-assistance substrate 10 arranged at an opposite side of the plasma generation device within the vacuum chamber 1.

The deposition-assistance substrate 10 has a negative bias voltage applied thereto by a bias voltage application oriented power supply 12. Alkali metal ions in the plasma are provided with acceleration energies by the bias voltage applied to the deposition-assistance substrate 10, and are irradiated toward the deposition-assistance substrate 10. Simultaneously, fullerene is sublimated by a fullerene sublimation oven 8, and injected toward the deposition-assistance substrate 10 from a fullerene vapor introduction pipe 9. Alkali metal ions collide with a fullerene film 11 deposited on the deposition-assistance substrate, thereby forming alkali-metal-containing fullerene.

Usable as a material of the deposition-assistance substrate is an electroconductive material such as stainless steel, aluminum, copper, or the like. Although the optimum value of the bias voltage (absolute value) to be applied to the deposition-assistance substrate varies depending on kinds of a deposited organic material film, ions to be implanted thereinto, and the like, it is desirable to control it within a range of 20V to 500V in case of Na-containing C₆₀. The bias voltage to be applied and an acceleration energy of ion are proportional to each other, such that application of a bias voltage of -1 V causes an Na⁺ ion to obtain an acceleration energy of 1 eV. It becomes possible to give acceleration energies to ions, by influencing a negative bias voltage on positive ions or a positive bias voltage on negative ions.

Acceleration energies of 20 eV or lower make it difficult for Na to be contained in a cage of fullerene, and acceleration energies of 500 eV or higher lead to collision of Na thereby tending to breakage of a fullerene cage. Acceleration energies within a range of 20 eV to 500 eV facilitates containment of Na into a cage, and scarcely cause breakage of a fullerene cage.

According to the ion implantation method of the present invention, confined within a magnetic field is plasma including charged particles made of implantation target ions and charged particles of a polarity opposite to that of the implantation target ions, and the plasma is transported toward a deposition-assistance substrate, so that attractive forces mutually act on the charged particles constituting the plasma to prevent the plasma from diverging, thereby enabling ions at a high density to be implanted into a material film on the deposition-assistance substrate.

Second Concrete Example:
FIG. 1(b) is a cross-sectional view according to a second concrete example of an ion implantation apparatus of the present invention. The second concrete example of the present invention is an ion implantation apparatus configured to generate plasma made of alkali metal ions by a plasma generation device of a contact ionization type, irradiate the generated plasma toward a fullerene film deposited on a deposition-assistance substrate, thereby producing alkali-metal-containing fullerene.

Vacuum chamber 21 is evacuated to a vacuum of about 10⁻⁴ Pa by a vacuum pump 22. Alkali metal sublimation oven 24 sublimates alkali metal filled in the oven, and alkali metal vapor is injected against a hot plate 26 by an alkali metal vapor introduction pipe 25. The alkali metal vapor is ionized on the hot plate 26, thereby generating plasma made of alkali metal ions and electrons. The generated plasma is confined in an axial direction within the vacuum chamber 21 along a uniform magnetic field (B = 2 to 7 kG) formed by an electromagnetic coil 23, and becomes a plasma flow flowing from the hot plate 26 toward the deposition-assistance substrate 28.

The deposition-assistance substrate 28 arranged within the vacuum chamber 21 has a negative bias voltage applied thereto by a bias voltage application oriented power supply 30. Alkali metal ions in the plasma are provided with acceleration energies by the bias voltage applied to the deposition-assistance substrate 28, and are irradiated toward a fullerene film 29 previously deposited on the deposition-assistance substrate 28, so that the alkali metal ions collide with the fullerene film 29, thereby forming alkali-metal-containing fullerene.

The apparatus for previously depositing a fullerene film on the deposition-assistance substrate may be a deposition apparatus independent of the ion implantation apparatus of the present invention, or a deposition apparatus incorporated in the same vacuum chamber. Further, without limited to a vapor deposition method, it is possible to adopt a deposition method such as sputtering method, CVD method, or the like.

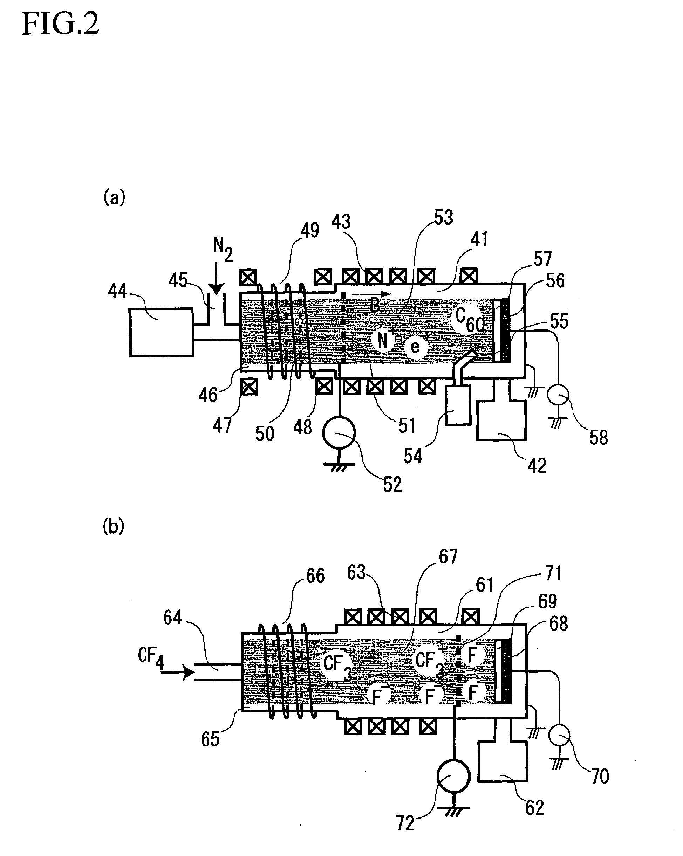

Third Concrete Example
FIG. 2(a) is a cross-sectional view according to a third concrete example of an ion implantation apparatus of the present invention. The third concrete example of the present invention is an ion implantation apparatus configured to generate plasma made of nitrogen ions by an ECR plasma generation device, and implant the generated nitrogen ions into fullerene, thereby producing nitrogen-containing fullerene.

Vacuum chamber 41 and plasma generation chamber 46 are mutually communicated vacuum vessels, respectively, and evacuated to a vacuum degree of about 10⁻⁴ Pa by a vacuum pump 42. There is introduced a nitrogen gas into the plasma generation chamber 46 from a nitrogen gas introduction pipe 45, and atoms, molecules, and the like constituting the nitrogen gas are excited by a microwave oscillator 44, thereby generating nitrogen plasma. Electromagnetic coils 47, 48 are made of circular ones arranged in a manner separated from each other and surrounding the plasma generation chamber 46, and electric currents are flowed through the electromagnetic coils in the same direction. There are formed strong magnetic fields near the electromagnetic coils 47, 48, and a weak magnetic field between the electromagnetic coils 47, 48. In the strong magnetic fields, there is caused repulsion of ions, electrons, and the like such that temporarily confined plasma of a high energy is formed, thereby allowing generation of plasma 50 numerously including N⁺ ions each made of one nitrogen.

PMH antenna 49 is provided for supplying a high-frequency power (13.56 MHz, MAX 2 kW) by changing phases of multiple coil elements, thereby resultingly causing a larger electric field difference between the coil elements. This causes the plasma 50 generated within the plasma generation chamber 46, to be highly dense over the entire region.

The generated plasma 50 is confined in an axial direction within the vacuum chamber 41 along a uniform magnetic field (B = 2 to 7 kG) formed by an electromagnetic coil 43, and becomes a plasma flow 53 flowing from the plasma generation chamber 46 toward a deposition-assistance substrate 56 arranged within the vacuum chamber 41. It becomes possible to control energies of electrons in the plasma, by arranging a grid electrode 51 having a bias voltage applied thereto by a bias-oriented power supply 52, in the course of the plasma flow 53. The deposition-assistance substrate 56 has a negative bias voltage applied thereto by a bias voltage application oriented power supply 58. N⁺ ions in the plasma are provided with acceleration energies by the bias voltage applied to the deposition-assistance substrate 56, and are irradiated toward the deposition-assistance substrate 56. Simultaneously, fullerene is sublimated by a fullerene sublimation oven 54, and injected toward the deposition-assistance substrate 56 from a fullerene vapor introduction pipe 55. Nitrogen ions collide with a fullerene film 57 deposited on the deposition-assistance substrate 56, thereby generating nitrogen-containing fullerene.

Fourth Concrete Example
FIG. 2(b) is a cross-sectional view according to a fourth concrete example of an ion implantation apparatus of the present invention. The fourth concrete example of the present invention is an ion implantation apparatus configured to generate plasma from halogen atom ions by a plasma generation device of a high frequency induction type, and irradiate the generated plasma onto a fullerene film deposited on a deposition-assistance substrate, thereby producing halogen atom-containing fullerene.

Vacuum chamber 61 is evacuated to a vacuum degree of about 10⁻⁴ Pa by a vacuum pump 62. In case of production of containing-fullerene internally containing fluorine as a halogen atom, for example, there is introduced a source gas made of CF₄ from a gas introduction pipe 64 into a plasma generation chamber 65, and a high-frequency power is supplied to the source gas by a high frequency induction coil 66 arranged around the plasma generation chamber so as to excite the source gas, thereby generating plasma including CF₃⁺, F⁻, and electrons.

The generated plasma is confined in an axial direction within the vacuum chamber 61 along a uniform magnetic field (B = 2 to 7 kG) formed by an electromagnetic coil 63, and becomes a plasma flow flowing from the plasma generation chamber 65 toward a deposition-assistance substrate 68 arranged within the vacuum chamber 61. There is arranged a grid electrode 71 in the course of the plasma flow, having a positive bias voltage applied by a power supply 72. Positive ions in the plasma are subjected to repulsive forces from the positive voltage applied to the grid electrode 71, and thus fail to pass the grid electrode. Only fluorine ions and electrons are irradiated to the deposition-assistance substrate 68, thereby enabling removal of ions which are unnecessary for production of containing-fullerene.

The deposition-assistance substrate 68 has a positive bias voltage applied thereto by a bias voltage application oriented power supply 70. Fluorine ions in the plasma are provided with acceleration energies by the bias voltage applied to the deposition-assistance substrate 68, and irradiated toward a fullerene film 69 previously deposited on the deposition-assistance substrate 68, so that fluorine ions collide with the fullerene film 69 to form fluorine-containing fullerene.

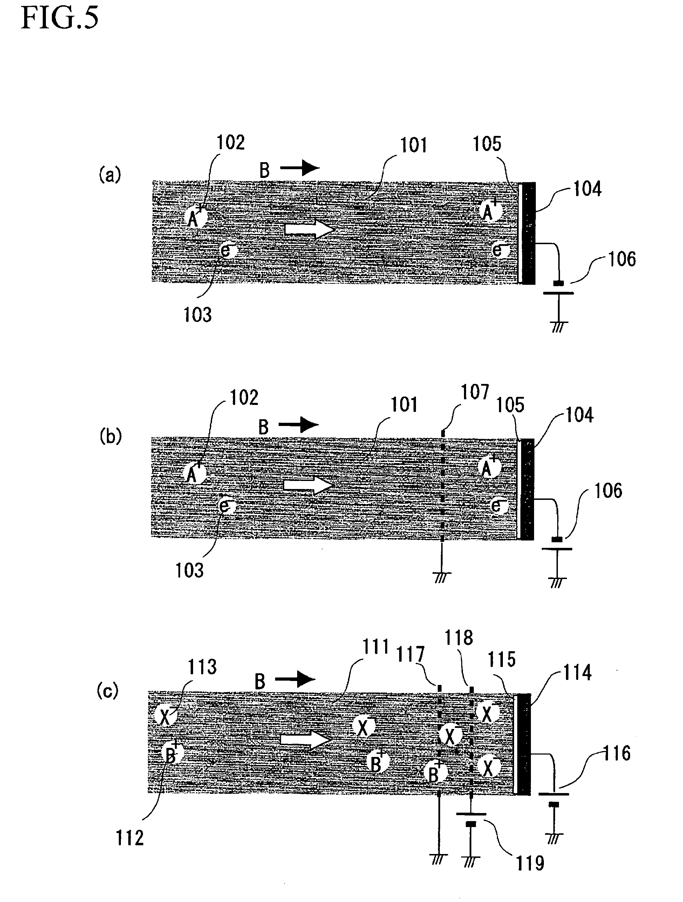

(Grid Electrode)
Although it is possible to directly irradiate a plasma flow to a deposition-assistance substrate, it is desirable to arrange a grid electrode in the course of the plasma flow to thereby irradiate the plasma flow while controlling a plasma potential by a bias voltage applied to the grid electrode. FIGS. 5(a), (b), and (c) are explanatory views of a function of a grid electrode according to the ion implantation apparatus of the present invention, respectively.

FIG. 5(a) is an explanatory view of a situation for achieving ion implantation by irradiating plasma including positive ions to a fullerene film without using a grid electrode for plasma potential control, and FIG. 5(b) is an explanatory view of a situation for achieving ion implantation by irradiating plasma including positive ions to a fullerene film by using a grid electrode for plasma potential control.

In FIG. 5(a), transported by a magnetic field is a plasma flow including electrons 103 of a polarity opposite to that of positive ions 102 as implantation targets. Positive ions 102 are accelerated by a negative bias voltage applied to a deposition-assistance substrate 104, thereby conducting ion implantation into a deposited film 105 on the deposition-assistance substrate 104. However, electrons 103 and positive ions 102 in the plasma are subjected to repulsive forces and attractive forces near the deposition-assistance substrate 104, respectively, so that a positive ion density is made higher than an electron density. This fails to keep a neutralizing condition of plasma, such that remaining charged particles constituting the plasma are repelled by each other, thereby tending to divergence of plasma flow.

Meanwhile, in FIG. 5(b), there is arranged a grid electrode 107 plasma-wise upstream of a deposition-assistance substrate 104, and separatedly from the deposition-assistance substrate 104. Further, the grid electrode 107 is set at a ground potential, for example. Although the bias voltage for plasma applied to the deposition-assistance substrate is effective in a plasma space between the grid electrode 107 and deposition-assistance substrate 104, the grid electrode 107 shields the influence of the bias voltage so that the bias voltage does not influence on the plasma-wise upstream of the grid electrode 107.

By providing the grid electrode 107 and adjusting it to a suitable potential, it becomes possible that a region where the bias voltage influences on a plasma flow is restricted to a region limited between the deposition-assistance substrate and the grid electrode. Namely, plasma is transported at a high density up to the grid electrode 107 while keeping a neutralizing condition, and is influenced by the bias voltage in the region between the grid electrode 107 and deposition-assistance substrate 104 to allow containment target atoms to be provided with acceleration energies, respectively. Distances between the deposition-assistance substrate 104 and grid electrode 107 are preferably within a range of 1 mm or more to 50 mm or less, thereby allowing for ion implantation at a high density even with lower acceleration energies.

FIG. 5(c) is an explanatory view of a situation for achieving ion implantation by irradiating plasma including negative ions of halogen element, for example, to a fullerene film. In FIG. 5(c), transported by a magnetic field is a plasma flow including positive ions 112 of a polarity opposite to that of negative ions 113 as implantation targets. Negative ions 113 are provided with acceleration energies by a positive bias voltage applied to a deposition-assistance substrate 114, thereby achieving ion implantation into a deposited film 115. There is arranged a grid electrode 118 plasma-wise upstream of the deposition-assistance substrate 114, and separatedly from the deposition-assistance substrate 114. Application of a positive bias voltage to the grid electrode 118 removes positive ions 112 unnecessary for ion implantation. There is additionally arranged a grid electrode 117 plasma-wise upstream of the grid electrode 118, and the grid electrode 117 is set at a ground potential, for example. The grid electrode 117 shields the influence of bias voltages applied to the deposition-assistance substrate 114 and grid electrode 118, so that the bias voltages do not influence on a plasma flow upstream of the grid electrode 117.

By providing the grid electrode 117 and adjusting it to a suitable potential, it becomes possible that a region where the bias voltage influences on a plasma flow is restricted to a region limited between the deposition-assistance substrate and the applicable grid electrode. Namely, plasma is transported at a high density up to the grid electrode 117 while keeping a neutralizing condition, and is influenced by the bias voltages in the region between the grid electrode 117 and deposition-assistance substrate 114 to allow containment target atoms to be provided with acceleration energies, respectively. Distances between the deposition-assistance substrate 114 and grid electrode 117 are preferably within a range of 1 mm or more to 50 mm or less, thereby allowing for ion implantation at a high density even with lower acceleration energies.

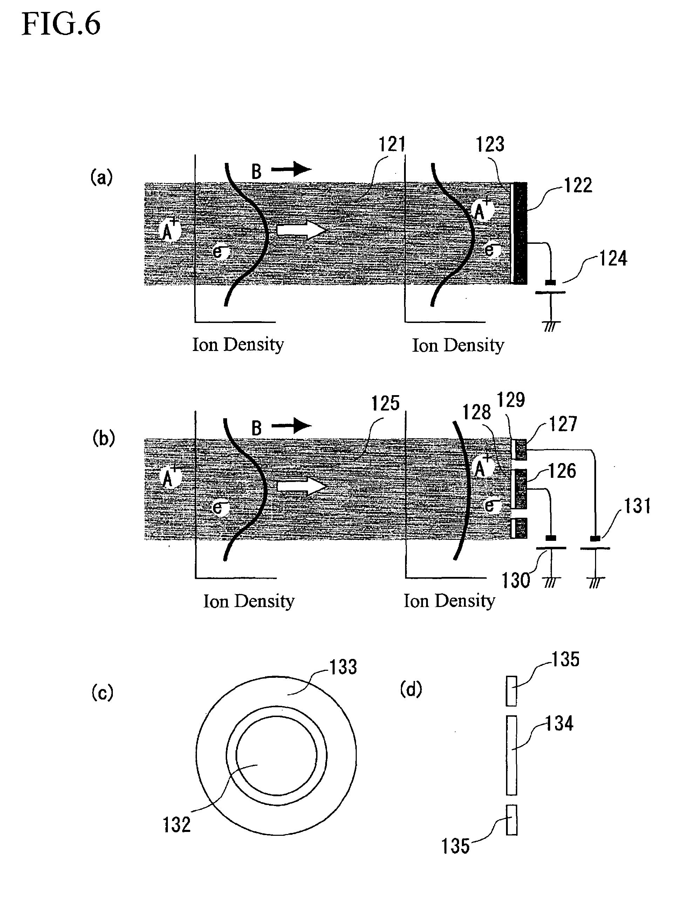

(Divided Substrate)
Although it is possible to adopt a single continuous substrate (undivided plate) as a substrate on which containing-fullerene is to be deposited, it is also possible to adopt a divided substrate depending on an ion density distribution in plasma. FIGS. 6(a), (b), and (c) are explanatory views of a function of a divided substrate according to the ion implantation apparatus of the present invention, respectively. For example, in case of plasma such as alkali metal plasma generated by using a plasma source of a contact ionization type, the ion density distribution in a cross section is not necessarily uniformalized and occasionally becomes a non-uniform one having a peak at a center of the cross section as shown in FIG. 6 (a).

FIG. 6(a) is a view showing an alkali metal ion density distribution in a plasma flow 121 in case of a deposition-assistance substrate made of an undivided plate. Although alkali metal ions are provided with acceleration energies by a deposition-assistance substrate having a uniform negative bias voltage within a cross section and are implanted into a fullerene film 123 deposited on the deposition-assistance substrate 122, ion densities within cross sections are similarly non-uniform at a position separated from the deposition-assistance substrate and a position near the deposition-assistance substrate such that the ion implantation amount is increased at a center of cross section and the ion implantation amount is decreased at an outer periphery of cross section, thereby decreasing a yield of containing-fullerene in the fullerene film along a periphery of the deposition-assistance substrate.

In turn, as shown in FIGS. 6(c) and (d), there is provided a deposition-assistance substrate in a planar shape constituted of divisional plates in concentric circle shapes matched with the plasma density distribution within the cross section, and independently controlled bias voltages are applied to the divisional plates, respectively, as shown in FIG. 6(b). For example, negative bias voltages from a bias power supply 131 and a bias power supply 130 are applied to a peripheral plate 127 and a center plate 126, respectively. When an absolute value of the bias voltage to the peripheral plate 127 is made larger than an absolute value of the bias voltage to the center plate 126, the peripheral plate exerts an attractive force larger than that of the center plate on alkali metal ions constituting a plasma flow, so that the alkali metal ion density distribution is further spread and becomes more uniform within the cross section. As such, densities of ions to be implanted are made more uniform at fullerene films 128 and 129, thereby enabling improvement of a yield of containing-fullerene.

(Control of Process Condition)
In the ion implantation apparatus of the present invention, it is also possible to provide means for measuring physical quantities such as densities, energies, and the like of ions and electrons in plasma, so as to control a process condition based on the measured physical quantities. For example, it is possible to arrange, at a front face of a deposition-assistance substrate, a Langmuir prove as means for measuring an electron density in plasma, in a manner to measure an electric current based on electrons flowing through the prove by a prove electric current measurement device, thereby measuring the electron density in the plasma. Depending on the measured values, it is possible to control a bias voltage to be applied to the deposition-assistance substrate, thereby further optimizing a yield of containing-fullerene. As a control method of a bias voltage, it is possible to manually control a bias voltage by an operator after viewing the measured values, or to conduct automatic control by a computer.

For example, the bias voltage is decreased in absolute value, in case of a higher ion or electron density. Alternatively, the bias voltage is decreased in absolute value, in case of a higher ion or electron energy. Controlling bias voltages enables optimum acceleration energies to be given to implantation target ions in plasma depending on a state of the plasma, thereby further improving a yield of containing-fullerene.

(Continuous Processing System)

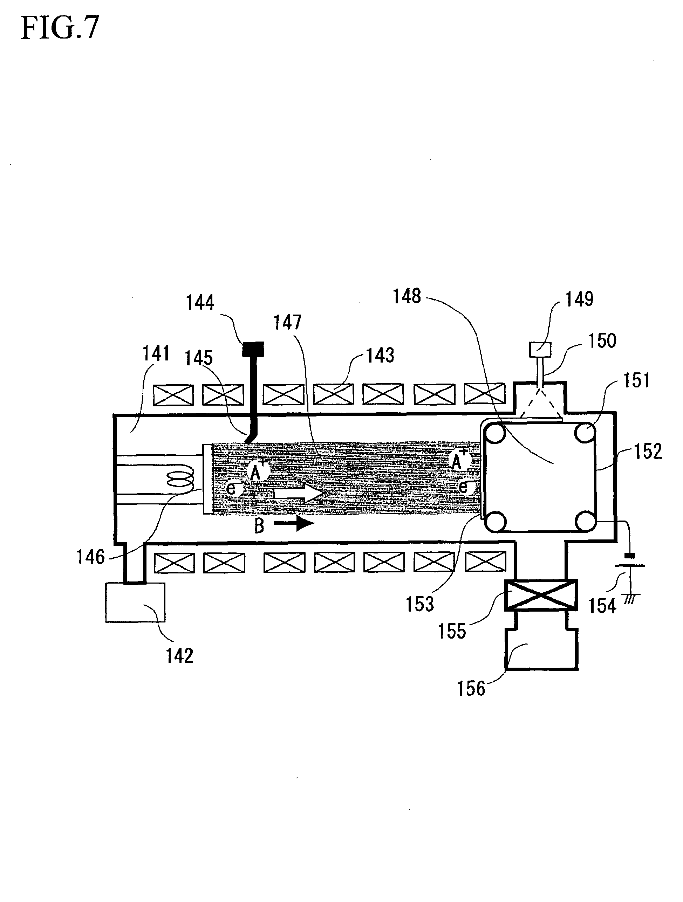

FIG. 7 is a cross-sectional view of an ion implantation apparatus of the present invention provided with a continuous processing system. The ion implantation apparatus shown in FIG. 7 is configured to continuously achieve deposition of a fullerene film and ion implantation into the fullerene film, by using the continuous processing system.

Vacuum chamber 141 is evacuated to a vacuum degree of about 10⁻⁴ Pa by a vacuum pump 142. Alkali metal sublimation oven 144 sublimates alkali metal filled in the oven, and alkali metal vapor is injected against a hot plate 146 by an alkali metal vapor introduction pipe 145. The alkali metal vapor is ionized on the hot plate 146, thereby generating plasma made of alkali metal ions and electrons.

The generated plasma is confined in an axial direction within the vacuum chamber 141 along a uniform magnetic field (B = 2 to 7 kG) formed by an electromagnetic coil 143, and becomes a plasma flow 147 flowing from the hot plate 146 toward the continuous processing system 148.

The continuous processing system 148 is constituted of: an electroconductive conveyor 152 simultaneously serving as a deposition-assistance substrate; and conveyor drive rollers 151. There are further provided a fullerene deposition apparatus and a containing-fullerene collection apparatus, adjacently to the continuous processing system 148.

The fullerene deposition apparatus is constituted of a fullerene sublimation oven 149 and a fullerene vapor introduction pipe 150, and is configured to inject fullerene vapor to the conveyor 152, thereby depositing a fullerene film on the conveyor 152. Further, the containing-fullerene collection apparatus is constituted of containing-fullerene collection means (not shown), a gate valve 155, and a load lock chamber 156.

The conveyor 152 is arranged so that a fullerene film 153 deposited on the conveyor 152 is movable through the fullerene deposition apparatus, the ion implantation apparatus, and the containing-fullerene collection apparatus. The ion implantation apparatus irradiates a plasma flow 147 onto a fullerene film deposited on the conveyor 151 by the deposition apparatus, and the bias voltage application oriented power supply 154 applies a negative bias voltage to the conveyor 152 so as to give acceleration energies to alkali metal ions in the plasma flow 147, to achieve ion implantation to produce containing-fullerene. The produced containing-fullerene is collected by the containing-fullerene collection means, and taken out into the load lock chamber 156.

The deposition process by the deposition apparatus, the ion implantation process by the ion implantation apparatus, the collection process of containing-fullerene by the collection apparatus, and driving of the conveyor are all synchronizedly controlled by a computer. It is possible to select, as a driving manner of the conveyor, any of (1) unidirectional continuous driving, (2) unidirectional stepped driving, and (3) bidirectional stepped driving.

Particularly, according to a method adopting the bidirectional stepped driving manner for eventually forming a containing-fullerene film of a predetermined film thickness, in a way to deposit an extremely thin layer of fullerene onto a deposition-assistance substrate in the deposition apparatus, and to thereafter repeat steps of: moving the fullerene layer to the ion implantation apparatus so as to implant containment target atoms into the fullerene layer; and again moving the fullerene layer to the deposition apparatus to deposit an extremely thin fullerene layer on the previous fullerene layer; it is possible to implant containment target atom ions uniformly in a thickness direction of the deposited fullerene film, thereby enabling a yield of containing-fullerene to be increased.

Further, it is possible to adopt automatic collection means for a containing-fullerene film, thereby automatically and continuously collecting a containing-fullerene formed on the conveyor 151. Simultaneously therewith, it is also possible to provide means for automatically supplying alkali metal to the alkali metal sublimation oven 144, and means for automatically supplying fullerene to the fullerene sublimation oven 149. This enables automatic supply of a starting material of containing-fullerene and automatic and simultaneous collection of containing-fullerene formed on the deposition-assistance substrate, to semipermanently continue production of containing-fullerene, thereby enabling mass-production of containing-fullerene.

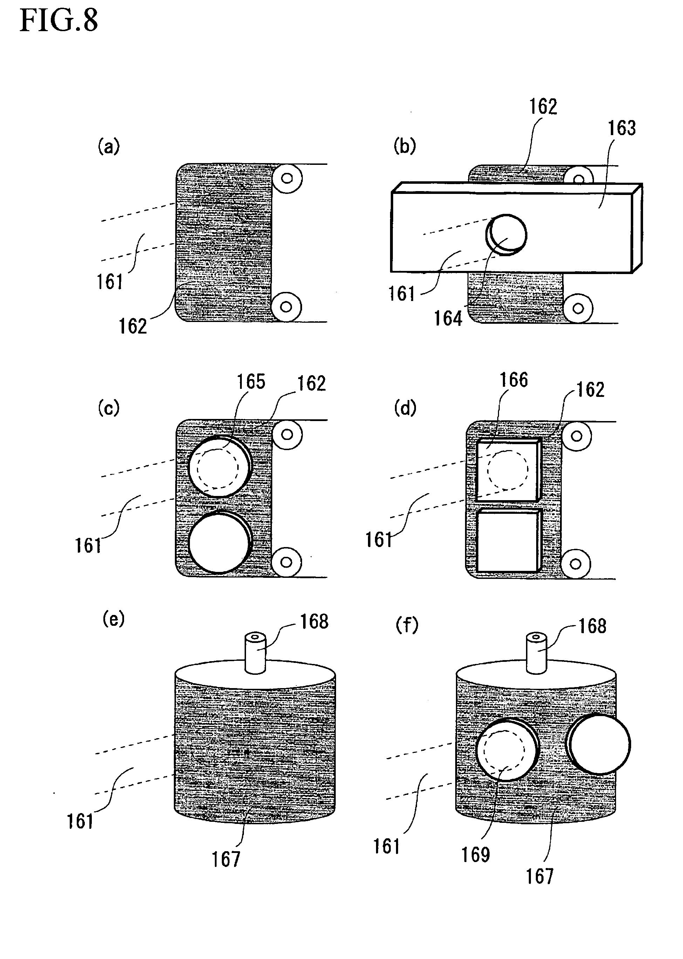

(Deposition-Assistance Substrate in Continuous Processing System)
According to the continuous processing system of the ion implantation apparatus of the present invention as explained above, it is possible to adopt a plurality of deposition-assistance substrates having configurations different from one another. FIGS. 8(a) through (f) are perspective views showing concrete examples of deposition-assistance substrates according to the continuous processing system, respectively.

FIG. 8(a) shows a deposition-assistance substrate in the configuration explained in the ion implantation apparatus of the present invention shown in FIG. 7. Plasma 161 is irradiated to a conveyor 162 driven by drive rollers, thereby implanting ions into a fullerene film (not shown) deposited on the conveyor 162.

FIG. 8(b) shows a deposition-assistance substrate where a shielding member against a plasma flow is arranged at a plasma side in front of a conveyor. Similarly to the deposition-assistance substrate shown in FIG. 8(a), plasma 161 is irradiated to the conveyor 162 driven by drive rollers, thereby implanting ions into a fullerene film (not shown) deposited on the conveyor 162. In case of the deposition-assistance substrate shown in FIG. 8(b), arranged at a plasma flow side near the deposition-assistance substrate, is a plasma flow shield plate 163 having an opening portion matched to a shape of plasma, for example. This enables prevention of ion implantation into a portion on the deposition-assistance substrate where ion implantation is not required.

Further, without achieving deposition of a fullerene film or implantation of ions directly onto a conveyor, it is also possible to achieve deposition of a fullerene film or implantation of ions onto a single or a plurality of deposition-assistance substrates 165 mounted on the conveyor 162. FIG. 8(c) shows a situation where deposition-assistance substrates are circular, and FIG. 8(d) shows a situation where deposition-assistance substrates are rectangular or square. It is of course possible that deposition-assistance substrates to be mounted on the conveyor each have an arbitrary shape other than circular and rectangular.

FIGS. 8(e) and (f) are perspective views, respectively, of a continuous processing system in a situation where the continuous processing system is driven not by a conveyor but by a cylinder rotatable about a rotational shaft 168. FIG. 8(e) shows a situation where deposition of a fullerene film and implantation of ions are conducted directly onto a rotary cylinder 167, and FIG. 8(f) shows a situation where deposition of a fullerene film and implantation of ions are conducted onto deposition-assistance substrates 169 mounted on the rotary cylinder 167.

Note that although FIGS. 8(e) and (f) show examples where the rotational shaft of the rotary cylinder is oriented in a vertical direction, the rotational shaft of the rotary cylinder can be arranged in an arbitrary direction such as a horizontal direction.

In the continuous processing system configured to conduct formation of a fullerene film and implantation of ions by mounting a deposition-assistance substrate on a conveyor or rotary cylinder, it is possible to readily achieve collection of containing-fullerene by detaching a deposition-assistance substrate(s) from the conveyor or rotary cylinder.

(Electrical Conduction Means and Substrate Cooling Means)
As a deposition-assistance substrate to be mounted on the conveyor or rotary cylinder, it is not necessarily possible to use a substrate made of an electroconductive material, and it is occasionally obliged to use a deposition-assistance substrate at least a part of which is electrically insulative. For example, in case of achieving ion implantation into a material film constituting an organic EL or organic solar cell, ions are to be occasionally implanted into a material film, acting as a deposition-assistance substrate, on a substrate which includes an insulating material and which has electrodes. Occasionally, there are adopted a glass substrate having electrodes or a plastic substrate having electrodes as a substrate having electrodes, and ITO, aluminum, or silver as a material of the electrodes. As a material of the plastic substrate, it is possible to adopt PET, PES, and the like.

Even in case of ion implantation into a material film on a substrate which includes an insulating material and which has electrodes, it becomes possible to apply a bias voltage from an external bias power supply to the material film as an implantation target, by establishing a structure which adopts electroconductive materials as members for mounting the deposition-assistance substrate onto a conveyor or rotary cylinder such as members for clamping and fixing the deposition-assistance substrate, in a manner that the electroconductive conveyor or rotary cylinder is electrically conducted to an electroconductive portion of the material film or deposition-assistance substrate as the implantation target.

Further, during irradiation of plasma onto a material film upon ion implantation, it is also occasional that a temperature of the deposition-assistance substrate is raised. Even in such a case, it is possible to achieve ion implantation at a high density to a plastic substrate such as PET or PES having a lower heat resistance, by arranging, on a conveyor or rotary cylinder, means such as a cooling water circulation apparatus for cooling the deposition-assistance substrate.

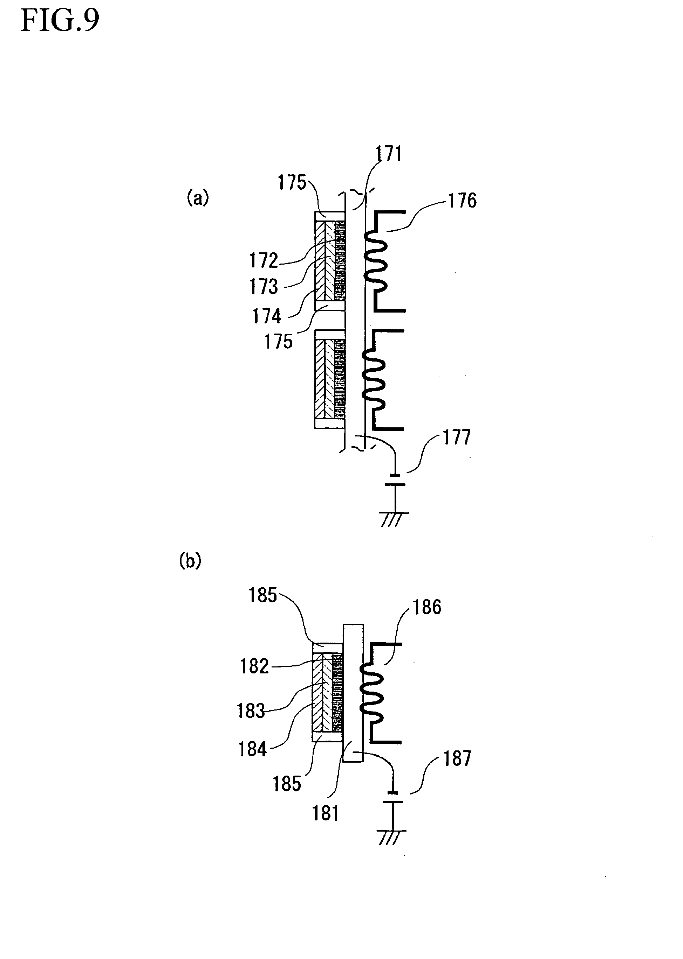

FIG. 9(a) is a cross-sectional view of a deposition-assistance substrate in the ion implantation apparatus of the present invention provided with electrical conduction means and cooling means. In the continuous processing system, a plurality of deposition-assistance substrates are clamped by electroconductive clamp members 175 fixed to a deposition-assistance substrate support member 171 such as a conveyor, so that the substrates are mounted on the deposition-assistance substrate support member 171. The deposition-assistance substrates are each a multi-layer substrate constituted of a plastic substrate 172 and an ITO electrode 173. Ion implantation is conducted to an organic material film 174 deposited by a vapor deposition method onto the associated ITO electrode 173, according to the ion implantation method of the present invention. Although the applicable plastic substrate 172 is electrically insulative, the clamp members 175 are electroconductive and act as electrical conduction means so that a bias voltage supplied from a bias voltage application oriented power supply 177 is applied to the applicable ITO electrode 173 via deposition-assistance substrate support member 171 and clamp members 175, thereby enabling that ions to be implanted into the associated organic material film 174 are provided with implantation energies. In turn, it is possible to cool the deposition-assistance substrate support member 171 by cooling means 176 such as a cooling water circulation apparatus, so as to prevent the applicable plastic substrate 172 from deformation and degradation due to heating during ion implantation process.

It is possible to use the electrical conduction means for applying bias voltages to material films as implantation target and the cooling means for preventing heat generation in a deposition-assistance substrate, not only in the continuous processing system shown in FIG. 9(b), but also in ion implantation adopting a single deposition-assistance substrate as shown in FIG. 9(b).

FIG. 9(b) is a cross-sectional view of a single deposition-assistance substrate provided with electrical conduction means and cooling means in the ion implantation apparatus of the present invention. Mounted on a deposition-assistance substrate support member 181 is a multi-layer substrate made of a plastic substrate 182 and an ITO electrode 183 and clamped by clamp members 185. Deposited on the ITO electrode 183 is an organic material film 184. The deposition-assistance substrate support member 181 is provided with cooling means 186. In case of the deposition-assistance substrate shown in FIG. 9(b), it is possible to conduct application of bias voltage to the ITO substrate and cooling of the deposition-assistance substrate, similarly to the deposition-assistance substrates shown in FIG. 9(a).

(Production of Materials other than Containing-Fullerene)
Application fields of the ion implantation methods of the present invention for implanting containment target atoms into fullerene as explained above are not limited to production of containing-fullerene.

The ion implantation methods of the present invention provide a remarkable effect when the same are applied to high density ion implantation to an organic material film or polymer material film which requires high density ion implantation with a low energy because ion implantation at a high energy typically breaks molecules constituting the film. For example, the ion implantation methods of the present invention can be preferably utilized in application fields where ions to be matured into containment target materials or impurity materials are implanted into carbon nanotube, material film of organic EL, material film of solar cell, material film of fuel cell, organic semiconductor material film, electroconductive polymer material film, and the like. Further, the ion implantation methods of the present invention can be preferably used in production of hetero-fullerene where ions are implanted into fullerene to thereby substitute carbon atom(s) constituting the fullerene by the implanted atom(s).

(Implantation Energy)
The phrases "low implantation energy" or "low acceleration energy" as used in the present invention refer to implantation energies which are low as compared with ion implantation energies of several KeV to several tens KeV to be typically used in a semiconductor process adopting an inorganic low molecular material such as silicon.

Concerning an implantation energy in case of implantation of a containment target material to which the ion implantation methods of the present invention are preferably applied, it is desirable that ion implantation is to be conducted at an implantation energy of 20 eV or higher so as to implant the containment target material into a molecule of a cage structure at a good efficiency. It is further desirable to conduct ion implantation at an implantation energy of 500 eV or lower, so as to avoid breakage of an implantation target film.

In case of implantation of impurity materials, it is possible to conduct ion implantation at low energies as compared with implantation of containment target materials, and it is desirable to use implantation energies of 0.5 eV or higher for conducting ion implantation at good efficiencies. Further, it is desirable to conduct ion implantation at implantation energies of 500 eV or lower so as to prevent breakage of implantation target films.

In case of production of hetero-fullerene, it is desirable to conduct ion implantation at implantation energies of 10 eV or higher, as an implantation condition that a substitution reaction of a fullerene molecule and an implantation target ion is easily caused. Further, it is desirable to conduct ion implantation at implantation energies of 500 eV or lower so as to prevent breakage of implantation target films.

(Ion Density)
The phrases "high density ion" or "high density ion implantation" as used in the present invention refer to such a degree of ion density that ion implantation can be conducted in a suitable implantation time for production of containing-fullerene or for physical property control of an organic or polymer material film. Concretely, as an ionic current per unit area, 1 µA/cm² or more is desirable, and 100 µA/cm² is more desirable.

(Implantation of Molecular Ion)
In case of implantation of containment target material into carbon nanotube or implantation of impurity material into an organic material film, polymer material film, or the like, it is possible for the ion implantation methods of the present invention to implant not only atomic ions but also molecular ions to be obtained by ionizing molecules.

According to the ion implantation methods of the present invention, molecular ions can be implanted at a high ion density into an implantation target film without breakage.

(Hetero-Fullerene)
"Hetero-fullerene" refers to fullerene where one or a plurality of carbon atoms constituting a fullerene molecule is/are substituted by atom(s) other than carbon, and examples of atoms for substituting for carbon atoms include nitrogen and boron. For example, the ion implantation methods of the present invention can be preferably used for production of hetero-fullerenes such as C₅₉N, C₆₉N, C₅₈BN, and C₆₈BN where a carbon atom(s) of fullerene is/are substituted by nitrogen or boron.

(Carbon Nanotube)
As an example where an implantation target film is carbon nanotube, the ion implantation methods of the present invention can be preferably used in a case that ions made of alkali metal or halogen element are implanted into an organic material film made of a single layer nanotube or multi-layer nanotube to be used in FET.

Conducting ion implantation into the organic material film enables achievement of control of physical properties such as electrical conductivity of the organic material film.

(Material Film of Organic EL)
As an example where an implantation target film is a material film constituting an electron transport layer of organic EL, the ion implantation methods of the present invention can be preferably used in a case that ions made of alkali metal are implanted into an organic material film made of 1,3,4-oxazole derivative (PBD) or 1,2,4-triazole derivative (TAZ).

Conducting ion implantation into the organic material film enables improvement of physical properties such as an electron implantation property thereof.

As an example where an implantation target film is a material film constituting a luminous layer of organic EL, the ion implantation methods of the present invention can be preferably used in a case that ions made of alkali metal are implanted into an organic material film made of tris(8-quinolinolato) aluminum complex (Alq3), bis(benzoquinolinolato) beryllium complex (BeBq2), bis(8-quinolato) zinc complex (Znq2), phenanthroline-based europium complex (Eu(TTA)3(phen)), polyparaphenylene vinylene, or polyfluorene.

Conducting ion implantation into the organic material film enables improvement of physical properties such as a light-emission efficiency thereof.

(Material Film of Solar Cell)
As an example where an implantation target film is a material film constituting a cathode, anode, or power generation layer of a solar cell, the ion implantation methods of the present invention can be preferably used in a case that ions made of alkali metal or C₆₀ are implanted into an organic material film made of poly-3-alkylthiophene or polyparaphenylene vinylene.
Conducting ion implantation into the organic material film enables improvement of physical properties such as an energy conversion efficiency thereof.

(Material Film of Fuel Cell)
As an example where an implantation target film is a material film such as an electrolyte film of a fuel cell, the ion implantation methods of the present invention can be preferably used in a case that ions made of Cs, Rb, K, Ba, Na, Sr, Ca, or Li are implanted into an organic material film made of fullerene.
Conducting ion implantation into the organic material film enables improvement of physical properties such as a proton conductivity, thereby decreasing an internal resistance of the fuel cell, for example.

(Organic Semiconductor Material Film)
As an example where an implantation target film is an organic semiconductor material film to be used in TFT and the like, the ion implantation methods of the present invention can be preferably used in a case that ions made of halogen elements or alkali metal are implanted into an organic material film made of pentacene, tetracene, perylene, or coumarin.
Conducting ion implantation into the organic material film enables improvement of physical properties such as a carrier mobility thereof.

(Electroconductive Polymer Material Film)
As an example where an implantation target film is an electroconductive polymer material film to be used in TFT, the ion implantation methods of the present invention can be preferably used in a case that ions made of alkali metal, halogen elements, or nitrogen are implanted into a polymer material film based on polypyrrole, polythiophene, polyaniline, polyacetylene, polythiazyl, or polyparaphenylene vinylene.

Conducting ion implantation into the polymer material film enables improvement of physical properties such as an electrical conductivity thereof.

### Embodiment 1

(Production Example of Containing-Fullerene)
Na-containing C₆₀ was produced by irradiating Na plasma to a material film made of fullerene C₆₀ according to the ion implantation method of the present invention. The conditions of fullerene film deposition and ion implantation were as follows:
Vacuum degree: 3×10⁻⁵ Pa
Electric-power for heating hot plate: 2.5 kW
Intensity of magnetic field: 2,000 G
Temperature of Na oven: 370°C
Temperature of Na vapor introduction pipe: 500°C
Deposition of fullerene film of 10 angstrom/cycle and ion implantation were repeated 10 times.

(Result of Mass Spectrometry)

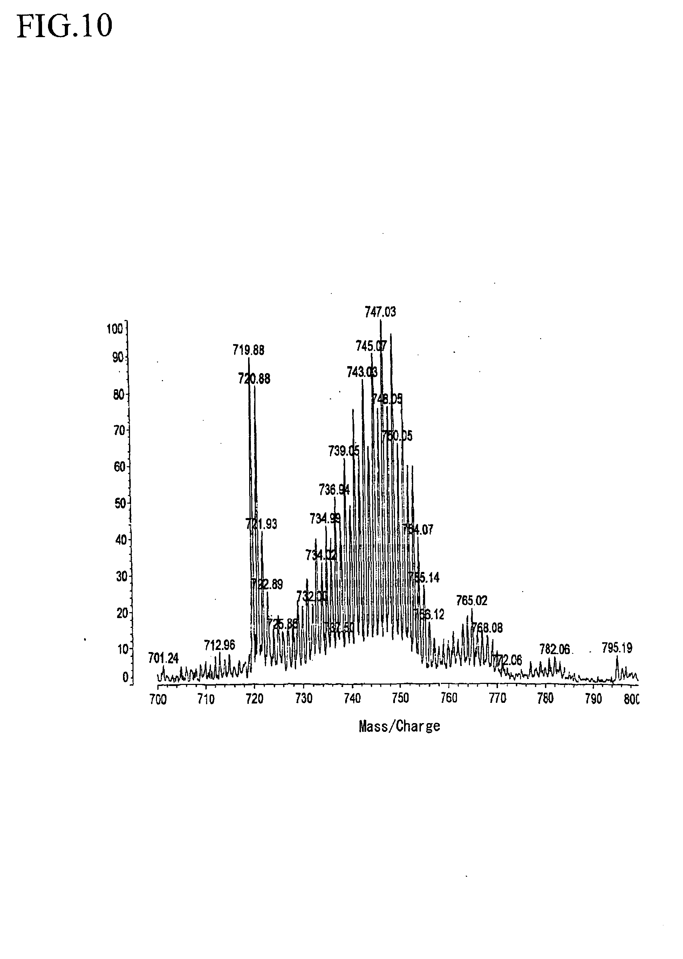

FIG. 10 is a graph showing a mass spectrometry result of Na-containing C₆₀ produced by the ion implantation method of the present invention. In addition to a peak at a mass of 720 representing empty C₆₀, there is also detected a peak at a mass of 743 representing Na-containing C₆₀.

(Implantation Energy Dependency of Yield)
There was produced Na-containing C₆₀ by implanting Na ions into C₆₀, and there was evaluated its implantation energy dependency of yield, so as to compare the ion implantation method of the present invention with a conventional ion implantation method based on ion beam irradiation.

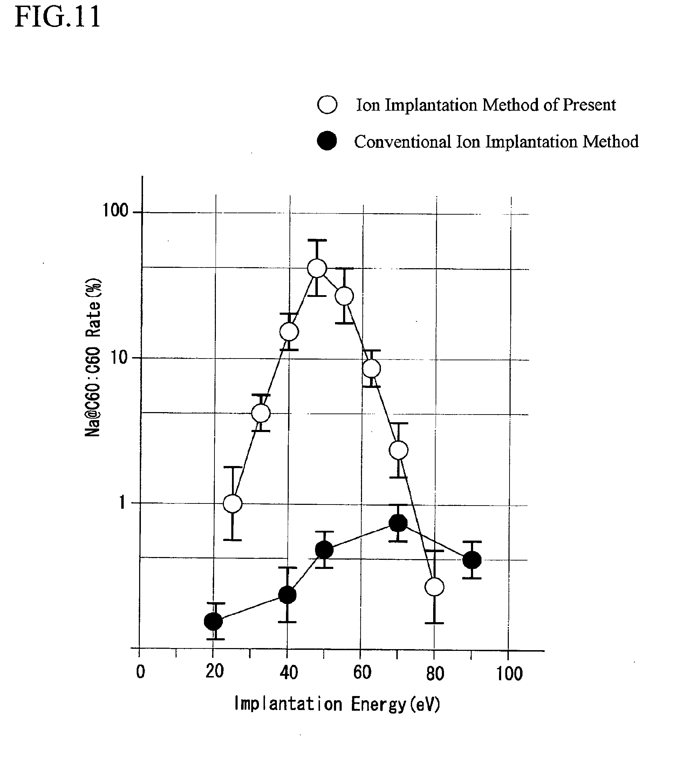

FIG. 11 is a graph showing an implantation energy dependency of a yield of Na-containing C₆₀.
In FIG. 11, according to the conventional ion implantation method represented by black circles, the yield of Na-containing C₆₀ becomes maximum under a condition of an acceleration energy of 70 eV for ion implantation, but the yield is less than 1% at the maximum. Further, there has been obtained a yield of 10% at the utmost, by the conventional fullerene plasma reaction method.
Contrary, according to the ion implantation method of the present invention represented by white circles, there can be obtained a yield of Na-containing C₆₀ which becomes a maximum of 50% at about 50 eV. Further, the yield is more than 10% in an acceleration energy range of 40 eV to 60 eV, thereby enabling obtainment of a yield which is one order higher than the conventional fullerene plasma reaction method.

Based on an experiment for producing containing-fullerenes by implanting various kinds of alkali metal ions into deposited films made of C₆₀ by the ion implantation method of the present invention, it has been confirmed that implantation energies for maximizing yields of containing-fullerenes differ depending on implantation target ions. Namely, although the yield in case of Na-containing fullerene was maximized under a condition of an implantation energy of about 50 eV, yields in case of Li-containing fullerene, K-containing fullerene, and Rb-containing fullerene were maximized under conditions of implantation energies of about 30 eV, about 60 eV, and about 80 eV, respectively.

### INDUSTRIAL APPLICABILITY

As described above, the ion implantation methods and ion implantation apparatuses according to the present invention are particularly useful for implantation of atomic ions and molecular ions into an organic material such as containing-fullerene and a polymer material where ion implantation with low energy and high density is required.

## Claims

1. An ion implantation method, **characterized in that** the method comprises the steps of:
generating, by plasma generation means, plasma at least including implantation target ions and charged particles of a polarity opposite to that of the implantation target ions;
transporting the plasma onto a deposition-assistance substrate under an influence of a magnetic field;
giving acceleration energies to the implantation target ions by a bias voltage applied by the deposition-assistance substrate;
irradiating the plasma toward the deposition-assistance substrate; and
implanting the implantation target ions into a material film on the deposition-assistance substrate.

2. The ion implantation method of claim 1, **characterized in that** the bias voltage has a polarity opposite to that of the implantation target ions.

3. The ion implantation method of any one of claims 1 and 2, **characterized in that** the plasma is irradiated to the material film deposited on the deposition-assistance substrate, to implant the implantation target ions into the material film.

4. The ion implantation method of any one of claims 1 and 2, **characterized in that** the plasma is irradiated toward the deposition-assistance substrate simultaneously with deposition of the material film onto the deposition-assistance substrate, to implant the implantation target ions into the material film.

5. The ion implantation method of any one of claims 1 and 2, **characterized in that** the implantation target ions are implanted into the material film by repeating:
a step of depositing a material film on the deposition-assistance substrate; and
the step of irradiating the plasma toward the deposition-assistance substrate.

6. The ion implantation method of any one of claims 1 through 5, **characterized in that** the ions are implanted into the material film comprising fullerene to produce containing-fullerene or hetero-fullerene.

7. The ion implantation method of claim 6, **characterized in that** the acceleration energies are within a range of 10 eV inclusive to 500 eV inclusive.

8. The ion implantation method of claim 6, **characterized in that** the acceleration energies are within a range of 20 eV inclusive to 500 eV inclusive.

9. The ion implantation method of any one of claims 1 through 5, **characterized in that** the material film is carbon nanotube, a material film of organic EL, a material film of solar cell, a material film of fuel cell, an organic semiconductor material film, or an electroconductive polymer material film.

10. The ion implantation method of claim 9,
**characterized in that** the acceleration energies are within a range of 0.5 eV inclusive to 500 eV inclusive.

11. The ion implantation method of any one of claims 1 through 10, **characterized in that** the implantation target ions have an ionic current density of 1 µA/cm² or more.

12. The ion implantation method of any one of claims 1 through 11, **characterized in that** the implantation target ions are implanted, by arranging a grid electrode in the plasma and separatedly from the deposition-assistance substrate to thereby control a plasma potential by a voltage applied to the grid electrode.

13. The ion implantation method of claim 12, **characterized in that** the grid electrode is located at a distance in a range of 1 mm inclusive to 50 mm inclusive from the deposition-assistance substrate.

14. The ion implantation method of any one of claims 1 through 13, **characterized in that** the implantation target ions are implanted, by providing the deposition-assistance substrate in a form of a plurality of divisional deposition-oriented plates in concentric circle shapes, and by independently controlling bias voltages applied to the plurality of deposition-oriented plates.

15. The ion implantation method of any one of claims 8 through 14, the implantation target ions are implanted, by cooling the deposition-assistance substrate by cooling means.

16. An ion implantation apparatus comprising:
a vacuum vessel;
plasma generation means for generating plasma at least including implantation target ions and charged particles of a polarity opposite to that of the implantation target ions, within said vacuum vessel;
magnetic field generating means;
a deposition-assistance substrate arranged within said vacuum vessel;
bias voltage application means for applying a bias voltage to said deposition-assistance substrate; and
material film deposition means for depositing a material film onto said deposition-assistance substrate.

17. An ion implantation apparatus comprising:
a vacuum vessel;
plasma generation means for generating plasma at least including implantation target ions and charged particles of a polarity opposite to that of the implantation target ions, within said vacuum vessel;
magnetic field generating means;
a deposition-assistance substrate arranged within said vacuum vessel; and
bias voltage application means for applying a bias voltage to said deposition-assistance substrate.

18. The ion implantation apparatus of any one of claims 16 and 17, **characterized in that** said deposition-assistance substrate comprises a conveyor or rotary cylinder.

19. The ion implantation apparatus of any one of claims 16 and 17, **characterized in that** said apparatus includes a transport device comprising a belt conveyor or rotary cylinder, and
that said transport device is configured to support and transport a plurality of said deposition-assistance substrates within said vacuum device.

20. The ion implantation apparatus of claim 19, **characterized in that** said deposition-assistance substrates are each supported to said transport device by an electroconductive clamp member.

21. The ion implantation apparatus of any one of claims 17 through 20, **characterized in that** said ion implantation apparatus further comprises cooling means for cooling said deposition-assistance substrate.
